Europäisches Patentamt

(19) European Patent Office

Office européen des brevets

(11) Publication number : **0 238 228 B1**

## (12) EUROPEAN PATENT SPECIFICATION

(45) Date of publication of patent specification :
10.07.91 Bulletin 91/28

(51) Int. Cl.⁵ : **G11C 11/409**

(21) Application number : 87301766.9

(22) Date of filing : 27.02.87

(54) Semiconductor memory.

(30) Priority : 18.03.86 JP 62052/86

(43) Date of publication of application :
23.09.87 Bulletin 87/39

(45) Publication of the grant of the patent :
10.07.91 Bulletin 91/28

(84) Designated Contracting States :
DE FR GB

(56) References cited :
DE-B- 2 647 394
IEEE JOURNAL OF SOLID-STATE CIRCUITS,
vol. SC-19, no. 4, August 1984, pages 451-454,
IEEE, New York, US; N.C.-C. LU et al.:
"Half-Vdd bit-line sensing scheme in CMOS
DRAM's"
IBM TECHNICAL DISCLOSURE BULLETIN,
vol. 22, no. 1, June 1979, pages 214-216, IBM
Corp., New York, US; G.W. LEEHAN: "Charge
shuttle clock driver"
IEEE ISSCC, 28. Febr. 85, New York, US,
pp252-253, SAITO et al.: "A 1 Mb CMOS DRAM
with Fast Page and Static Column Modes"

(73) Proprietor : MITSUBISHI DENKI KABUSHIKI
KAISHA
2-3, Marunouchi 2-chome Chiyoda-ku
Tokyo 100 (JP)

(72) Inventor : Miyamoto, Hiroshi
c/o Mitsubishi Denki K.K.§LSI Kenkyusho
1 Mizuhara 4-chome§Itami-shi§Hyogo-ken
(JP)
Inventor : Yamada, Michihiro
c/o Mitsubishi Denki K.K.§LSI Kenkyusho
1 Mizuhara 4-chome§Itami-shi§Hyogo-ken
(JP)

(74) Representative : Beresford, Keith Denis Lewis
et al
BERESFORD & Co. 2-5 Warwick Court High
Holborn
London WC1R 5DJ (GB)

## Description

The present invention relates to a dynamic random access memory (dynamic RAM). In particular it concerns a memory having a folded bit-line structure and formed by a CMOS process.

EP-A-0 239 208 and EP-A-0 239 225, both falling under Article 54(3) EPG, disclose a dynamic RAM having a folded bit-line structure and in which CMOS amplifier and restore circuit parts are separated and located each side of each memory block.

A dynamic RAM having a folded bit-line structure is known and is described for example in United States Patent No 4, 122, 546 (Von Basse et al). In one arrangement, shown in figure 3 of this reference, the memory cells are connected to a pair of bit-lines and the latter arranged across a weighting network, specifically an MOS flip-flop, located at one end of the pair of bit-lines and on one side only of all the memory cells. This replaces an earlier type of structure in which the memory cells are connected to lines extending each side of the weighting network. Because of the line pairing and localised arrangement of memory cells, more consistent electrical properties and thus improved behaviour are said to be attainable. A similar arrangement is also described in the article entitled "A 1 Mb CMOS DRAM with Fast Page and Static Column Modes" by Saito, S. et al in IEEE International Solid State Circuits Conference, 28 Feb 1985, New York, USA, pages 252 and 253. In this arrangement a CMOS amplifier (having a sense amplifier portion and a restore circuit portion, respectively, formed of complementary conductivity type transistors) is used in place of the flip-flop weighting network.

A dynamic RAM generally employs a memory cell comprising a single transistor and a single capacitor. In this case, the smaller the ratio of capacitance of a bit-line to capacitance of a capacitor in a memory cell is, the larger amount of change in potential on a bit-line at the time of read-out is, and the larger input potential difference for a sense amplifier is, so that read-out operation is ensured. However, as the density of a memory is increased significantly and integration increased, the size of each memory cell is made smaller, and consequently the capacitance of each capacitor is reduced. On the other hand, since the number of memory cells connected to a single bit-line is also increased, each bit line becomes longer, and thus the capacitance of each bit-line tends to be increased. As a result, the ratio of the capacitance of each bit-line to the capacitance of each memory capacitor is increased, so that eventually read-out operation can become unreliable.

To solve this problem, each bit-line is divided up and the memory cells are divided into a corresponding plurality of blocks so that the ratio of the capacitance of a memory capacitor to the capacitance of each bit line is then reduced.

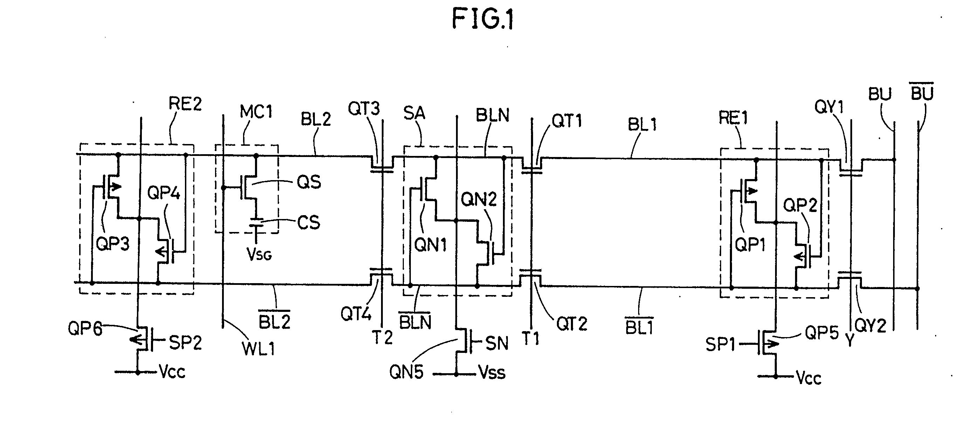

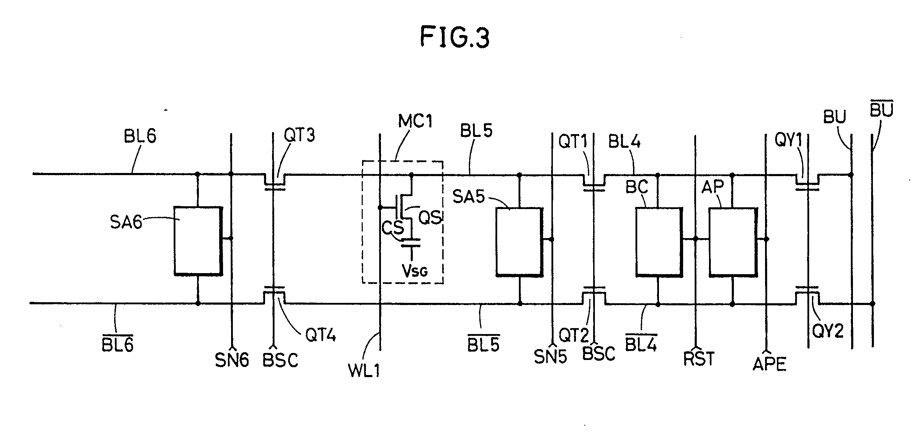

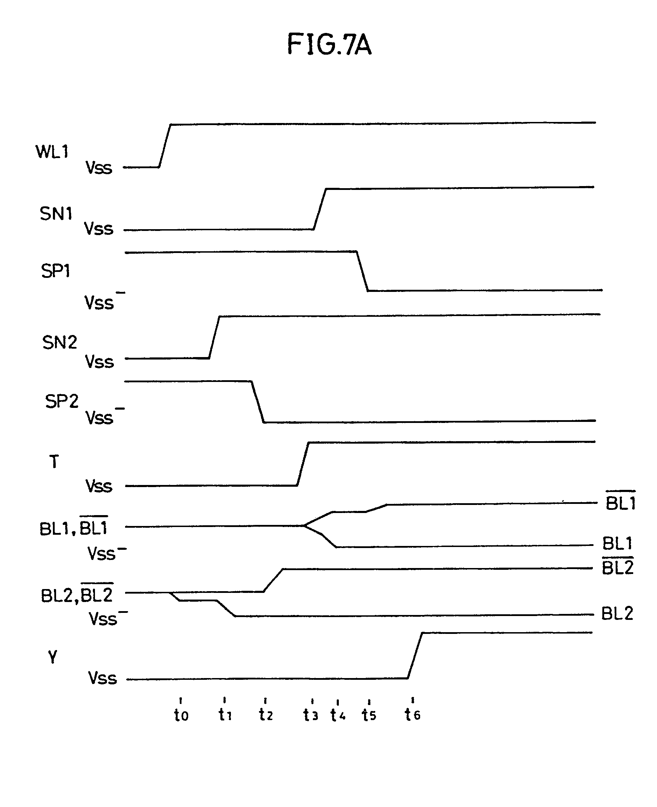

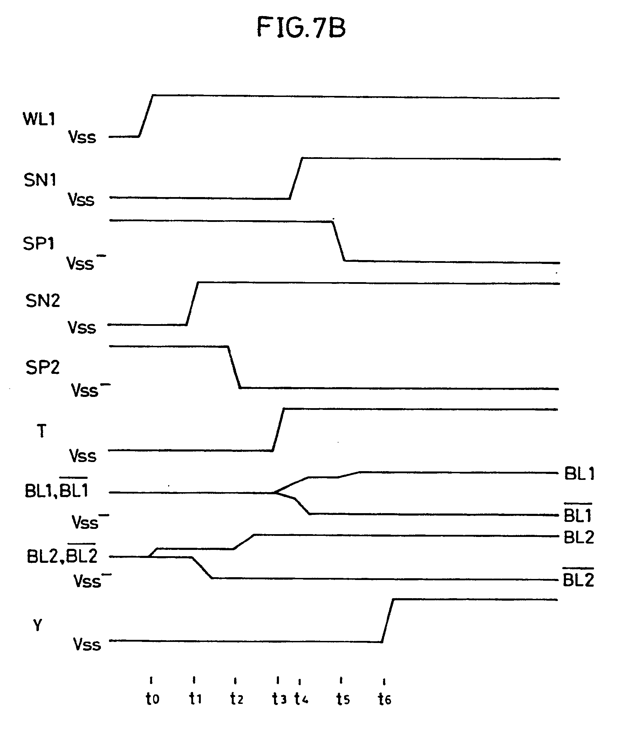

This is shown in the arrangement of figure 7 of, and is discussed in, the reference US 4, 122, 546 just acknowledged. In the more recent development of dynamic RAM the functions of pull-up and pull-down amplification have been performed respectively by spaced sense amplifiers and restore circuits of complementary transistor type. In each of the two examples shown in figures 1 and 3 either a sense amplifier or a restore circuit is provided adjacent to each memory cell block and the other is provided either as a shared resource, one between two (figure 1) or as a common resource, at one end of the paired bit-line (figure 3). As will be outlined below, each of these arrangements proves to be disadvantageous.

Fig. 1 is a circuit diagram showing a structure of a part of a conventional dynamic RAM, which is disclosed in, for example, an article by R.I. Kung et al., entitled "A Sub 100ns 256 K DRAM in CMOS III Technology", Digest of Technical Papers, ISSCC 84, pp. 278-279. The structure of this circuit is now described. In Fig. 1, a so-called shared sense amplifier structure is shown wherein a bit line is divided into two parts and a sense amplifier is inserted and shared between the divided bit lines on both sides. In the above described document, the transistor in the memory cell comprises a p channel MOS transistor, the sense amplifier comprises p channel MOS transistors, and the restore circuit comprises n channel MOS transistors. For simplicity of illustration, these transistors have a conductivity type opposite to the above described conductivity type, in Fig. 1. In addition, the structure of the circuit is slightly simplified, so that only a pair of folded bit lines out of a plurality of pairs of folded bit lines is shown.

A pair of folded bit lines are divided into divided bit lines BL1, BLN, BL2, $\overline{BL1}$, $\overline{BLN}$ and $\overline{BL2}$. The divided bit lines BLN and $\overline{BLN}$ are paired and connected to a sense amplifier SA for discharging the bit line at a low potential to a ground potential. The divided bit lines BL1 and $\overline{BL1}$ are paired and connected to a restore circuit RE1 for charging the bit line at a high potential to a power supply potential. The divided bit lines BL2 and $\overline{BL2}$ are paired and connected to a restore circuit RE2 for charging the bit line at a high potential to the power supply potential.

The sense amplifier SA comprises an n channel MOS transistor QN1 having a drain connected to the divided bit line BLN, a gate connected to the divided bit line $\overline{BLN}$ and a source connected to one conduction terminal of a sense amplifier driver transistor QN5, and an n channel MOS transistor QN2 having a drain connected to the divided bit line $\overline{BLN}$, a gate connected to the divided bit line BLN and a source connected to one conduction terminal of the sense amplifier driver transistor QN5. The sense amplifier driver transistor QN5 is turned on in response to a sense amplifier activating signal applied to the gate thereof, so that a ground potential $V_{SS}$ is transferred to the sources of the transistors QN1 and QN2.

The restore circuit RE1 comprises a p channel MOS transistor QP1 having a drain connected to the divided bit line BL1, a gate connected to the divided bit line $\overline{BL1}$ and a source connected to one conduction terminal of a restore circuit driver transistor QP5, and a p channel MOS transistor QP2 having a drain connected to the divided bit line $\overline{BL1}$, a gate connected to the divided bit line BL1 and a source connected to one conduction terminal of the restore circuit driver transistor QP5. The restore circuit driver transistor QP5 is turned on in response to a restore circuit activating signal SP1 applied to the gate thereof, so that a power supply potential $V_{CC}$ is transferred to the sources of the transistors QP1 and QP2.

The restore circuit RE2 comprises a p channel MOS transistor QP3 having a drain connected to the divided bit line BL2, a gate connected to the divided bit line $\overline{BL2}$ and a source connected to one conduction terminal of a restore circuit driver transistor QP6, and a p channel MOS transistor QP4 having a drain connected to the divided bit line $\overline{BL2}$, a gate connected to the divided bit line BL2 and a source connected to one conduction terminal of the restore circuit driver transistor QP6. The restore circuit driver transistor QP6 is turned on in response to a restore circuit activating signal SP2, so that the power supply potential $V_{CC}$ is transferred to the sources of the transistors QP3 and QP4.

The divided bit lines BL1 and BLN are connected to each other through a transfer gate QT1 forced of an n channel MOS transistor, and the divided bit lines $\overline{BL1}$ and $\overline{BLN}$ are connected to each other through a transfer gate QT2 formed of an n channel MOS transistor. The transfer gates QT1 and QT2 are turned on in response to a transfer signal T2.

The divided bit lines BLN and BL2 are connected to each other through a transfer gate QT3 formed of an n channel MOS transistor. The divided bit lines $\overline{BLN}$ and $\overline{BL2}$ are connected to each other through a transfer gate QT4 formed of an n channel MOS transistor. The transfer gates QT3 and QT4 are turned on in response to a transfer signal T2.

The divided bit line BL1 and a bus line BU for transferring data are connected to each other through a column gate transistor QY1 formed of an n channel MOS transistor. The divided bit line $\overline{BL1}$ and a bus line $\overline{BU}$ for transferring data are connected to each other through a column gate transistor QY2 formed of an n channel MOS transistor. The column gate transistors QY1 and QY2 are turned on in response to a column selecting signal Y. Although many memory cells, the number of which depends on memory capacity, are connected to each of the divided bit lines, only one of these, memory cell MC1, which is connected to the divided bit line BL2 is shown. This memory cell MC1 comprises an n channel MOS transistor QS and a capacitor CS. The transistor QS has a gate being a part of a word line WL1 and a source connected to the divided bit line BL2. The capacitor CS has one electrode connected to the drain of the transistor QS and another electrode connected to a memory cell plate potential $V_{SG}$.

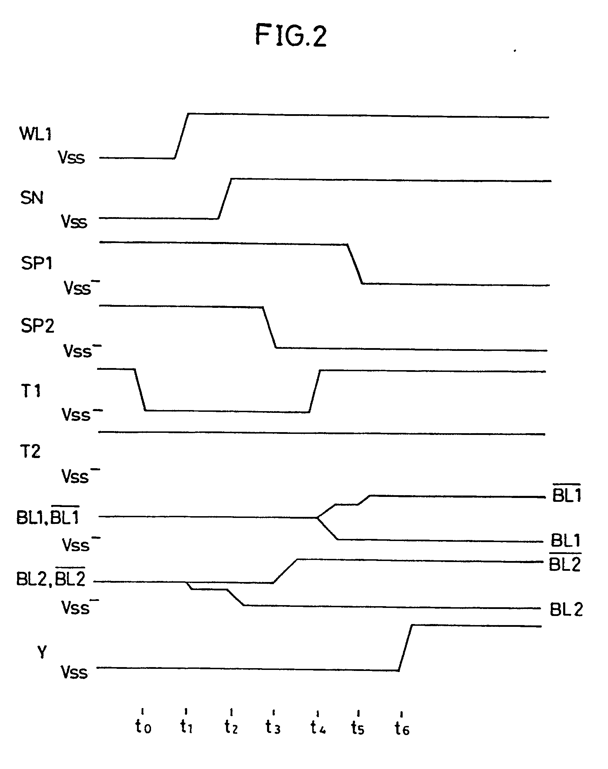

Fig. 2 is a waveform diagram for explaining operation at the time of read-out of information stored in the memory shown in Fig. 1. Referring now to Fig. 2 which is a waveform diagram explaining operation of the circuit shown in Fig. 1, how information is read out is described when the capacitor CS in the memory cell MC1 is not charged, that is, when information "0" is stored.

At time $t_0$, the transfer signal T1 becomes an "L" level. Accordingly, the divided bit lines BLN and BL1 are isolated from each other and the divided bit lines $\overline{BLN}$ and $\overline{BL1}$ are isolated from each other. By that time, the divided bit lines BL1, $\overline{BL1}$, BL2, $\overline{BL2}$, BLN and $\overline{BLN}$ have been precharged at an intermediate potential level $(V_{CC}-V_{SS})/2$, where $V_{CC}$ is a power supply potential and $V_{SS}$ is a ground potential. At time $t_1$, the potential on the selected word line WL1 becomes an "H" level. Accordingly, MOS transistor QS is turned on. As a result, the potential on the divided bit line BL2 fall slightly, and a potential difference develops between the divided bit lines BL2 and $\overline{BL2}$.

At time $t_2$, a sense amplifier activating signal SN becames and "H" level. As a result, potential difference is increased between the divided bit lines BL2 and $\overline{BL2}$. More specifically, the potential on the divided bit line BL2 is held near the above described intermediate potential, while the divided bit line BL2 is discharged through the transfer gate transistor QT3 and the sense amplifier SA, so that the potential thereon becomes near to the ground potential $V_{SS}$.

At time $t_3$, the restore circuit activating signal SP2 becomes an "L" level. As a result, the potential on the divided bit line $\overline{BL2}$ is pulled up near the power supply potential $V_{CC}$ by the restore circuit RE2, so that potential difference is further increased between the divided bit lines BL2 and $\overline{BL2}$.

At time $t_4$, the transfer signal T1 becomes again an "H" level. Thus, the potential on the divided bit lines BLN and $\overline{BLN}$ are transferred to the divided bit lines BL1 and $\overline{BL1}$. As result, the divided bit line BL1 is discharged, so that the potential thereon becomes near to the ground potential $V_{SS}$, while the potential on the divided bit line $\overline{BL1}$ is pulled up.

At time $t_5$, the restore circuit activating signal SP1 becomes an "L" level. As a result, the potential on the divided bit line $\overline{BL1}$ is pulled up near to the power supply potential $V_{CC}$.

At time $t_6$, the column selecting signal Y becomes an "H" level. Thus, the potential on the divided bit lines BL1 and BL1 are transferred to the bus lines BU and BU, so that the information "0" stored in the memory cell MC1 is read out.

In the circuit shown in Fig. 1, information stored in the capacitor CS in the memory cell MC1 is read out onto the divided bit line BL2, so that the potential difference between the divided bit lines BL2 and $\overline{BL2}$ is amplified by the sense amplifier SA. At that time, the divided bit line BL2 is discharged at the sense amplifier SA through a transfer gate transistor QT3. In a dynamic RAM with a folded bit line structure, each bit line is generally formed of low resistive material such as aluminium or refractory metal silicide. Therefore, resistance of the bit line can be reduced, and discharge of charges on the bit line can be accelerated. However, in a dynamic RAM with a shared sense amplifier structure, a transfer gate transistor is provided between a divided bit line connected to a memory cell and a sense amplifier, so that a bit line cannot be formed of a low resistive material in this transfer gate transistor portion. In addition, as shown in Fig. 1, since the transfer gate transistor must be provided for each pitch between bit lines, the transistor width can be made almost the same as or at most twice the pitch between bit lines. Since the pitch between the bit lines is, for example, about 3 μm in a 1 Mega-bit dynamic RAM, the transistor with of the transfer gate transistor is limited to less than several μm. As a result, conductance of the transfer gate transistor is reduced, and discharge of charges on the divided bit line is delayed when the sense amplifier operates. Furthermore, since a source and a drain of the transfer gate transistor are formed of a diffusion layer provided in a substrate or a well, noise is transferred to a bit line through the substrate or the well, so that the sense amplifier erroneously operates.

Fig. 3 is a circuit diagram showing a part of a structure of another conventional dynamic RAM, which is disclosed in the Japanese Laying-Open Gazette No. 101093/1984. The structure of this circuit is now described. In Fig. 3, the circuit comprises only n channel MOS transistors. For simplicity of illustration, only a pair of folded bit lines out of a plurality of pairs of folded bit lines, are shown herein.

The pair of folded bit lines are divided into three pairs of divided bit lines BL4 and $\overline{BL4}$, BL5 and $\overline{BL5}$ and BL6 and $\overline{BL6}$. The pair of divided bit lines BL4 and $\overline{BL4}$ are connected to an active pull-up circuit AP which is activated in response to an active pull-up signal APE for boosting the potential on the bit line at a high potential to the power supply potential, and a bit line precharge circuit BC for precharging the potential on the bit line to the intermediate potential.

The pair of divided bit lines BL5 and $\overline{BL5}$ are connected to a sense amplifier SA5 which is activated in response to a sense amplifier driver signal for further increasing potential difference between the pair of divided bit lines.

The pair of divided bit lines BL6 and $\overline{BL6}$ are connected to a sense amplifier SA6 which is activated in response to the sense amplifier driver signal for further increasing potential difference between the pair of divided bit lines.

The divided bit lines BL4 and BL5 are connected to each other through the transfer gate transistor QT1, while the divided bit lines $\overline{BL4}$ and $\overline{BL5}$ are connected to each other through the transfer gate transistor QT2. The transfer gate transistors QT1 and QT2 are turned on in response to a transfer signal BSC.

The divided bit lines BL5 and BL6 are connected to each other through the transfer gate transistor QT3, while the divided bit lines $\overline{BL5}$ and $\overline{BL6}$ are connected to each other through the transfer gate QT4. The transfer gates QT3 and QT4 are turned on in response to the transfer signal BSC.

The divided bit line BL4 and the bus line BU for transferring data are connected to each other through the column gate transistor QY1, while the divided bit line BL4 and the bus line BU for transferring data are connected to each other through the column gate transistor QY2. The column gate transistors QY1 and QY2 are turned on in response to a column selecting signal.

Although many memory cells, the number of which depends on a memory capacity, are connected to the divided bit lines BL5, $\overline{BL5}$, BL6 and $\overline{BL6}$, only one of these, memory cell MC1, which is connected to the divided bit line BL5 is shown. The memory cell MC1 comprises the transfer transistor QS and the capacitor CS. The transistor QS has a gate being a part of the word line WL1. The capacitor CS has one electrode connected to the memory cell plate potential $V_{SG}$.

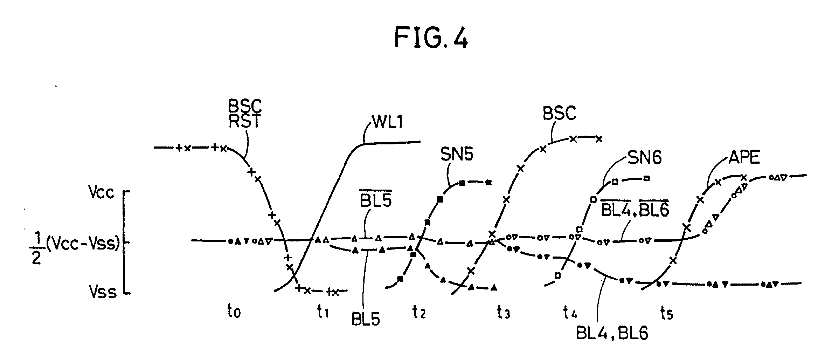

Fig. 4 is a waveform diagram explaining operation at the time of read-out of information stored in the circuit shown in Fig. 3.

Referring now to Fig. 4 which is a waveform diagram explaining operation of the circuit shown in Fig. 3, how information is read out is described when the capacitor CS in the memory cell MC1 is not charged, that is, when information "0" is stored.

Before time $t_0$, the transfer signal BSC and a reset signal RST become an "H" level. Accordingly, all the transfer gate transistors QT1 to QT4 are turned on. Thus, the divided bit lines BL4, BL5 and BL6 are connected to each other, while the divided bit lines $\overline{BL4}$, $\overline{BL5}$ and $\overline{BL6}$ are connected to each other. In addition, since the reset signal RST becomes an "H" level, the bit line precharge circuit BC operates, so that each of the divided bit lines is precharged, so that the potential thereon becomes the intermediate potential ($V_{CC}$-$V_{SS}$)/2.

At time $t_1$, both the transfer signal BSC and the reset signal RST become an "L" level, and the selected word line WL1 becomes an "H" level. As a result, the potential on the divided bit line BL5 slightly falls, so that potential difference occurs between the divided bit lines BL5 and $\overline{BL5}$.

At time $t_2$, a sense amplifier activating signal SN5 becomes an "H" level. Accordingly, the sense amplifier SA5 is activated. As a result, potential difference is increased between the divided bit lines BL5 and $\overline{BL5}$.

At time $t_3$, the transfer signal BSC becomes an "H" level. Accordingly, the transfer gate transistors QT1 to QT4 are turned on. As a result, the potentials on the divided bit lines BL5 and $\overline{BL5}$ are transferred to the divided bit lines BL4 and BL6 and $\overline{BL4}$ and $\overline{BL6}$, respectively.

At time $t_4$, a sense amplifier activating signal SN6 becomes an "H" level. As a result, potential difference is increased between the divided bit lines BL6 and $\overline{BL6}$, so that potential difference is increased between the divided bit lines BL4 and $\overline{BL4}$ and between the divided bit lines BL5 and $\overline{BL5}$.

At time $t_5$, the active pull-up signal APE becomes an "H" level. Accordingly, the active pull-up circuit AP operates. As a result, the potential on the divided bit lines $\overline{BL4}$, $\overline{BL5}$ and $\overline{BL6}$ is pulled up near the power supply potential $V_{CC}$. Then, the column selecting signal Y becomes an "H" level. Thus, the potential on the divided bit lines BL4 and $\overline{BL4}$ are transferred to the bus lines BU and $\overline{BU}$, so that information "0" stored in the memory cell MC1 is read out.

In the circuit shown in Fig. 3, a sense amplifier is provided for each pair of divided bit lines, while an active pull-up circuit is provided not for each pair of divided bit lines but for each pair of folded bit lines. Therefore, since the potential on an entire bit line of each pair of folded bit lines must be pulled up by a single active pull-up circuit when the active pull-up circuit operates, the active pull-up circuit having large drive capacity is required, and the area of the circuit increases. Additionally, in order to pull up the potential on each of the divided bit lines to the power supply potential $V_{CC}$ by the active pull-up circuit, the gate potential of a transfer gate transistor, that is, the transfer signal BSC must be boosted over the power supply potential $V_{CC}$. However, integration of a memory increases, a gate oxide film of the transfer gate transistor tends to be thinner. For example, the gate oxide film in a 1 Mega-bit dynamic RAM is approximately 200 to 300 Å in thickness. Therefore, if the gate potential is boosted over the power supply potential $V_{CC}$, reliability of the gate oxide film is reduced.

The present invention is intended as a remedy for the problems aforesaid.

The dynamic RAM of the present invention is a dynamic RAM of the type comprising :

a plurality of paired bit-lines, each pair of bit-lines being divided into a plurality of divided bit-line pairs ;

a multiplicity of memory cells divided into blocks, each block of memory cells being connected to a respective one of the divided bit line pairs and having each side, respectively, a sense amplifier having one or more transistors of one conductivity type and a restore circuit having one or more transistors of the complementary conductivity type ; and

a control circuit for generating sense amplifier activating signals for activating sequentially said plurality of sense amplifiers in a predetermined order commencing with that one of the sense amplifiers included in that one of the blocks including that one of the memory cells that is being addressed, wherein

each respective sense amplifier and each respective restore circuit are connected to the respective divided bit-line pair ; and

each respective divided bit-line pair is divided from the next by one pair of switches, one switch in each bit-line ; there being included :

a control means for controlling operation of said one pair of switches, responsive to that pair of sense amplifier activating signals applied respectively to the sense amplifiers in the blocks that are immediately adjacent to said one pair of switches, and operable to render said one pair of switches conductive to follow and in response to whichever one of said pair of sense amplifier activating signals is first to go active.

Since in this invention each respective memory cell, sense amplifier and restore circuit are connected to a common divided bit line pair, the initial sensing and restoration operation can be performed prior to transfer operation. Delay otherwise arising due to transfer via the resistive channel of a transfer gate transistor, as in state of the art construction (figure 1), is obviated and accordingly access time is improved. Also, since both a sense amplifier and a restore circuit are provided for each memory cell/divided bit-line section, the problems of common sensing and/or restoration (e.g. figure 3) are also avoided.

In the drawings :

Fig. 1 is a diagram showing a part of the structure of a conventional dynamic RAM ;

Fig. 2 is a waveform diagram explaining operation of the circuit shown in Fig. 1 ;

Fig. 3 is a diagram showing a part of the structure of another conventional dynamic RAM ;

Fig. 4 is a waveform diagram explaining operation of the circuit shown in Fig. 3 ;

Fig. 5 is a diagram showing main parts of the structure of a dynamic RAM, an embodiment of the present invention ;

Fig. 6 is a diagram showing a specific structure of a transfer signal generator shown in Fig. 5 ; and

Figs. 7A and 7B are waveform diagrams of signals explaining operation of the circuit shown in Fig. 5.

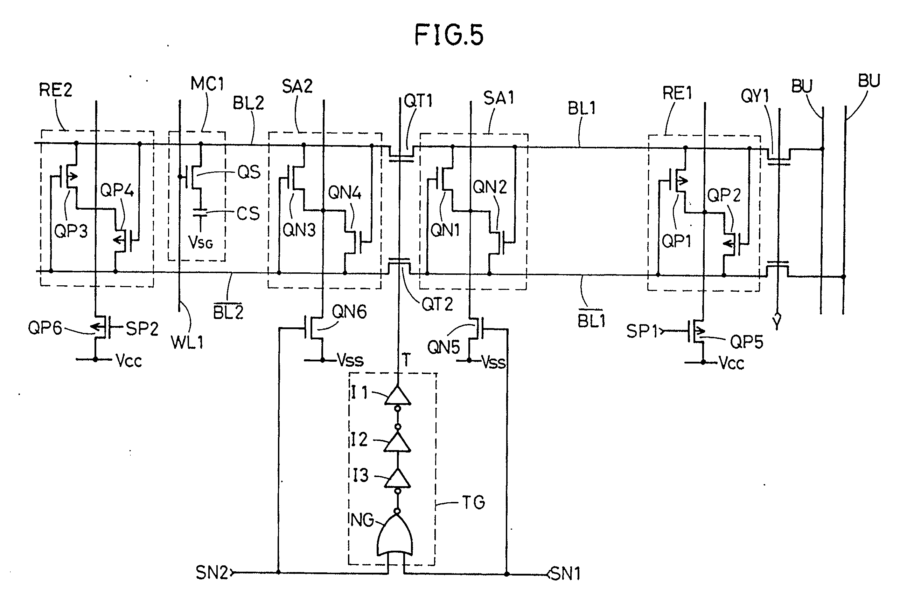

So that this invention shall be better understood, a preferred embodiment thereof will be described below and reference will be made to figures 5 to 7 of the drawings. The description that follows is given by way of example only.

Fig. 5 is a circuit diagram showing a structure of a dynamic RAM according to an embodiment of the present invention. The structure of the circuit is now described. For simplicity of illustration, only a pair of folded bit lines out of a plurality pairs of folded bit lines is shown in fig. 5.

A pair of folded bit lines are divided into the divided bit lines BL1, BL2, $\overline{BL1}$ and $\overline{BL2}$.

The pair of divided bit lines BL1 and $\overline{BL1}$ are connected to a sense amplifier SA1 for discharging the bit line on the side of a low potential so that the potential thereon becomes a ground potential $V_{SS}$, and a restore circuit RE1 for discharging the bit line on the side of a high potential so that the potential thereon becomes a power supply potential $V_{CC}$. The sense amplifier SA1 comprises an n channel MOS transistor QN1 having a drain connected to the divided bit line BL1 and a gate connected to the divided bit line $\overline{BL1}$, and an n channel MOS transistor QN2 having a drain connected to the divided bit line $\overline{BL1}$ and a gate connected to the divided bit line BL1. MOS transistors QN1 and QN2 have sources both connected to one conduction terminal of a sense amplifier driver transistor QN5. The sense amplifier driver transistor QN5 comprises an n channel MOS transistor, and is turned on in response to a sense amplifier activating signal SN1 applied to the gate thereof, so that the sources of the transistors QN1 and QN2 are connected to the ground potential $V_{SS}$. The restore circuit RE1 comprises a p channel MOS transistor QP1 having a drain connected to the divided bit line BL1 and a gate connected to the divided bit line $\overline{BL1}$, and a p channel MOS transistor QP2 having a drain connected to the divided bit line $\overline{BL1}$ and a gate connected to the divided bit line BL1. The transistors QP1 and QP2 have sources both connected to one conduction terminal of a restore circuit driver transistor QP5. The driver transistor QP5 comprises a p channel MOS transistor, and is turned on in response to a restore circuit activating signal SP1 applied to the gate thereof, so that the sources of the transistors QN1 and QN2 are connected to a power supply potential.

The pair of divided bit lines BL2 and $\overline{BL2}$ are connected to a sense amplifier SA2 comprising n channel MOS transistors QN3 and QN4, and a restore circuit RE2 comprising p channel MOS transistors QP3 and QP4. The sense amplifier SA2 is activated by a sense amplifier driver transistor QN6 which is turned on in response to a sense amplifier activating signal. The restore circuit RE2 is activated by a restore circuit driver transistor QP6 which is turned on in response to a restore circuit activating signal SP2.

The divided bit lines BL1 and BL2 and the divided bit lines $\overline{BL1}$ and $\overline{BL2}$ are connected to each other through transfer gate transistors QT1 and QT2 which are turned on in response to a transfer signal T, respectively. The transfer signal T is generated by a transfer signal generator TG in response to an active state of either the sense amplifier activating signal SN1 or SN2. The transfer signal generator TG comprises an NOR gate NG receiving the sense amplifier activating signals SN1 and SN2 and three-stage inverters I1, I2 and I3 receiving an output of the NOR gate NG. The three-stage inverters I1, I2 and I3 provide the delay time required for the transfer signal T to be generated, after transition of either the activating signal SN1 or SN2 to an active state.

The divided bit line BL1 is connected to a bus line BU for transferring data through a column gate transistor QY1 which is an n channel MOS transistor. The divided bit line $\overline{BL1}$ is connected to a bus line $\overline{BU}$ for transferring data through a column gate transistor QY2 which is an n channel MOS transistor. The column gate transistors QY1, QY2 are turned on in response to a column selecting signal Y applied to the gate thereof. Although memory cells are connected to each of the divided bit lines, depending on memory capacity, only a memory cell MC1 connected to the divided bit line BL2 is typically shown herein. The memory cell MC1 comprises a transfer transistor QS and a memory capacitor CS. The transfer transistor QS has a gate being a part of a word line WL1, and the memory capacitor CS has one electrode connected to a memory cell plate potential $V_{SG}$.

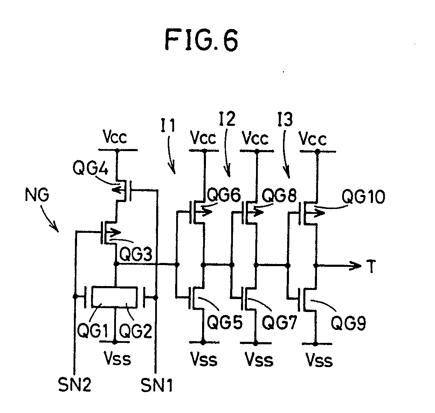

Fig. 6 is a circuit diagram showing an example of a specific structure of the transfer signal generator shown in Fig. 5. The NOR gate NG comprises p channel MOS transistors QG4 and QG3 having gates receiving the sense amplifier activating signals SN1 and SN2, respectively, and n channel MOS transistors QG2 and QG1 having gates receiving the sense amplifier activating signals SN1 and SN2, respectively. The inverter I1 comprises a p channel MOS transistor QG6 and an n channel MOS transistor QG5 connected in a complementary manner. The inverter I2 comprises an n channel MOS transistor QG7 and an n channel MOS transistor QG8 connected in a complementary manner. The inverter I3 comprises an n channel MOS transistor QG9 and a p channel MOS transistor QG10 connected in a complementary manner.

Fig. 7A is a waveform diagram for explaining read-out operation when a memory cell stores information "0". Referring now to Fig. 7A which is a waveform diagram for explaining operation, operation showing how information is read out is described when the capacitor CS in the memory cell MC1 is not charged, that is, when information "0" is stored.

Before time $t_0$, the divided bit lines BL1, $\overline{BL1}$, BL2 and $\overline{BL2}$ are precharged, so the potential thereon becomes an intermediate potential $(V_{CC}-V_{SS})/2$. In addition, the transfer signal T is at an "L" level.

At time $t_0$, the potential on the selected word line WL1 becomes an "H" level. Accordingly, the transistor QS is turned on. As a result, the potential on the divided bit line BL2 slightly lowers, so that potential difference occurs between the divided bit lines BL2 and $\overline{BL2}$.

At time $t_1$, the sense amplifier activating signal SN2 becomes an "H" level. Accordingly, the sense amplifier SA2 is activated. As a result, potential difference is increased between the divided bit lines BL2 and $\overline{BL2}$. More specifically, the potential on the divided bit line $\overline{BL2}$ is held near the above described intermediate potential, while the divided bit line BL2 is discharged through the sense amplifier SA2, so that the potential thereon becomes near the ground potential $V_{SS}$.

At time $t_2$, the restore circuit activating signal SP2 becomes an "L" level. Accordingly, the restore circuit RE2 is activated. As a result, the potential on the divided bit line $\overline{BL2}$ is pulled up near the power supply potential $V_{CC}$ through the restore circuit RE2, so that potential difference is further increased between the divided bit lines BL2 and $\overline{BL2}$.

At time $t_3$, the transfer signal T becomes an "H" level which was triggered by high going of the sense amplifier activating signal SN2. Thus, the potential on the divided bit lines BL2 and $\overline{BL2}$ are transferred to the divided bit lines BL1 and $\overline{BL1}$, respectively. At that time, the divided bit line BL1 begins to be discharged through the transfer gate transistor QT1 and the sense amplifier SA2, while the potential on the divided bit line $\overline{BL1}$ begins to be pulled up from the above described intermediate potential through the transfer gate transistor QT2 and the restore circuit RE2.

At time $t_4$, the sense amplifier activating signal SN1 becomes an "H" level. Accordingly, the sense amplifier SA1 operates. As a result, the divided bit line BL1 is discharged, so that the potential thereon becomes rear the ground potential $V_{SS}$.

At time $t_5$, the restore circuit activating signal SP1 becomes an "L" level. Accordingly, the restore circuit RE1 operates. As a result, the potential on the divided bit line BL1 is pulled up near the power supply potential $V_{CC}$.

At time $t_6$, the column selecting signal Y becomes an "H" level. Accordingly, the column gate transistors QY1 and QY2 are turned on. Thus, the potentials on the divided bit lines BL1 and $\overline{BL1}$ are transferred to the bus lines BU and $\overline{BU}$, so that information "0" stored in the memory cell MC1 is read out.

Fig. 7B is a waveform diagram of signals explaining operation for reading out information when information "1" is stored in a memory cell. Referring now to Fig. 7B which is a waveform diagram explaining operation, operation showing how information is read out is described when the capacitor CS in the memory cell MC1 is charged, that is, when information "1" is stored.

Before time $t_0$, the divided bit lines BL1, $\overline{BL1}$, BL2 and $\overline{BL2}$ are precharged to the intermediate potential, and the transfer signal T becomes an "L" level, as when information "0" is read out.

At time $t_0$, the selected word line WL1 becomes an "H" level. Accordingly, the MOS transistor QS is turned on. As a result, the potential on the divided bit line BL2 slightly rises, so that potential difference occurs between the divided bit lines BL2 and $\overline{BL2}$.

At time $t_1$, the sense amplifier activating signal SN2 becomes an "H" level. Accordingly, the sense amplifier SA2 operates. As a result, potential difference is increased between the divided bit lines BL2 and $\overline{BL2}$. More specifically, the potential on the divided bit line BL2 is held to the potential which is a little higher than the above described intermediate potential, while the divided bit line $\overline{BL2}$ is discharged through the sense amplifier SA2, so that the potential thereon becomes near the ground potential $V_{SS}$.

At time $t_2$, the restore circuit activating signal SP2 becomes an "L" level. As a result, the potential on the divided bit line BL2 is pulled up near the power supply potential $V_{CC}$ through the restore circuit RE2, so that potential difference is further increased between the divided bit lines BL2 and $\overline{BL2}$.

At time $t_3$, the transfer signal T becomes an "H" level, which was triggered by high going of the sense amplifier activating signal SN2. Thus, the potential on the divided bit lines BL2 and $\overline{BL2}$ are transferred to the divided bit lines BL1 and $\overline{BL1}$, respectively. At that time, the divided bit line $\overline{BL1}$ begins to be discharged through the transfer gate transistor QT2 and the sense amplifier SA2, while the potential on the divided bit line BL1 begins to be pulled up from the above described intermediate potential through the transfer gate transistor QT1 and the restore circuit RE2.

At time $t_4$, the sense amplifier activating signal SN1 becomes an "H" level. Accordingly, the sense amplifier SA1 operates. As a result, the divided bit line $\overline{BL1}$ is discharged, so that the potential thereon becomes near the ground potential $V_{SS}$.

At time $t_5$, the restore circuit activating signal SP1 becomes an "L" level. Accordingly, the restore circuit RE1 operates. As a result, the potential on the divided bit line BL1 is pulled up near the power supply potential $V_{CC}$.

At time $t_6$, the column selecting signal Y becomes an "H" level. Accordingly, the column gate transistors QY1 and QY2 are turned on. Thus, the potentials on the divided bit lines BL1 and $\overline{BL1}$ are transferred to the bus lines BU and $\overline{BU}$, so that information "1" stored in the memory cell MC1 is read out.

It is noted that when information stored in, for example, the memory cell MC1 is read out, the transfer signal T, having a delay of a predetermined time, is generated in response to the sense amplifier activating signal SN2 of the sense amplifier SA2 which was first operated, so that the transfer gate transistors QT1 and QT2 are turned on. As a result, after the potential difference between the divided bit lines BL2 and $\overline{BL2}$ is increased sufficiently by the sense amplifier SA2 and the restore circuit RE2, the increased potential difference is transferred to the divided bit lines BL1 and $\overline{BL1}$. It follows that the sensing operation is stabilized and the operating margin of the semiconductor memory is increased accordingly.

Furthermore, since restore circuits are provided one for each pair of divided bit lines, active pull-up circuits having large area and large drive capacity are not a requisite. In the conventional memory, in order to pull up the potential on an entire bit line of a pair of folded bit lines by a single active pull-up circuit, the gate potential of the transfer gate transistor between the pair of divided bit lines must be boosted over the power supply potential $V_{CC}$, and accordingly the gate oxide film of the transfer gate transistor can be degraded. However, in the above embodiment, since a restore circuit is provided for each pair of divided bit lines, the gate potential of the transfer gate transistors QT1 and QT2 need not be boosted over the power supply potential $V_{CC}$. Reliability of the gate oxide film of the transfer gate transistor is ensured accordingly. In addition, the speed of reading out information stored in the semiconductor memory can be increased.

Although in the above described embodiment, each sense amplifier comprises an n channel MOS transistor, and each restore circuit comprises a p channel MOS transistor, the sense amplifier and the restore circuit may each comprise a MOS transistor of conductivity type opposite to the above provided that the polarity of each of the activating signals is suitably selected.

Furthermore, although in the above described embodiment, the transfer gate transistor and the column gate transistor each comprise an n channel MOS transistor, the transfer gate transistor and the column gate transistor may each comprise a p channel MOS transistor if signals applied to the gates of these transistors are of suitable polarity. Additionally, although in the above described embodiment, the transistor of each memory cell is an n channel MOS transistor, the transistor of the memory cell may be a p channel MOS transistor provided that the potential on the word line is of suitable polarity.

Although in the above described embodiment, the transfer signal generator comprises a NOR gate and a three-stage inverter, the transfer signal generator may comprise inverters having a different number of stages or may comprise other suitable circuit configuration.

Although the present invention has been described and illustrated in detail, clearly it is to be understood that the same is by way of illustration and example only and is not to be taken by way of any limitation, the scope of the present invention being limited only by the terms of the claims that follow.

## Claims

1. A dynamic random access memory (fig.5) comprising :
a plurality of paired bit-lines, each pair of bit-lines being divided into a plurality of divided bit-line pairs (BL1 & $\overline{BL1}$, BL2 & $\overline{BL2}$) ;
a multiplicity of memory cells (MC1,...) divided into blocks, each block of memory cells being connected to a respective one of the divided bit line pairs (BL1 & $\overline{BL1}$, BL2 & $\overline{BL2}$,...) and having each side, respectively, a sense amplifier (SA1, SA2,...) having one or more MOS transistors (QN1 & QN2, QN3 & QN4...) of one conductivity type and a restore circuit (RE1, RE2) having one or more MOS transistors (QP1 & QP2, QP3 & QP4) of the complementary conductivity type and ;
a control circuit for generating sense amplifier activating signals (SN1, SN2) for activating sequentially said plurality of sense amplifiers (SA1, SA2) in a predetermined order (SA2, SA1) commencing with that one (SA2) of the sense amplifiers (SA1, SA2) included in that one of the blocks including that one (MC1) of the memory cells (MC1,...) that is being addressed, wherein each respective sense amplifier (SA1, SA2,...) and each respective restore circuit (RE1, RE2,...) are connected to the respective divided bit-line pair (BL1 & $\overline{BL1}$, BL2 & $\overline{BL2}$,...) ; and
each respective divided bit-line pair (BL1 & $\overline{BL1}$, BL2 & $\overline{BL2}$,...) is divided from the next (BL2 & $\overline{BL2}$,...) by one pair of switches (QT1 & QT2), one switch (QT1, QT2) in each bit-line ; there being included :
a control means (TG), for controlling operation of said one pair of switches (QT1 & QT2), responsive to that pair of sense amplifier activating signals (SN1, SN2) applied respectively to the sense amplifiers (SA1, SA2) in the blocks that are immediately adjacent to said one pair of switches (QT1 & QT2), and operable to render said one pair of switches (QT1 & QT2) conductive to follow and in response to whichever one of said pair of sense amplifier activating signals (SN1, SN2) is first to go active.

2. A semiconductor memory, as claimed in claim 1, wherein said control means (TG) comprises a NOR gate (NG) arranged to receive as inputs thereof the sense amplifier activating signals (SN1, SN2) for the two sense amplifiers (SA1, SA2) included in the two blocks immediately adjacent to the corresponding one pair of switches (QT1 & QT2).

3. A semiconductor memory, as claimed in claim 2, wherein said control means (TG) includes inverters (I1, I2, I3) connected in series to the output of said NOR gate (NG).

## Patentansprüche

1. Dynamischer Speicher mit wahlfreiem Zugriff (Fig. 5), umfassend

eine Vielzahl gepaarter Bitleitungen, wobei jedes Bitleitungspaar in eine Vielzahl geteilter Bitleitungspaare (BL1 & $\overline{\text{BL1}}$, BL2 & $\overline{\text{BL2}}$ unterteilt ist, eine Vielzahl von in Blöcke unterteilten Speicherzellen (MC1,...), wobei jeder Block von Speicherzellen mit einem der geteilten Bitleitungspaare (BL1 & $\overline{\text{BL1}}$, BL2 & $\overline{\text{BL2}}$,...) verbunden ist und an jeder Seite einen Leseverstärker (SA1, SA2,...) mit einem oder mehreren MOS-Transistoren (QN1 & QN2, QN3 & QN4...) eines Leitfähigkeitstyps bzw. einen Rücksetzkreis (RE1, RE2) mit einem oder mehreren MOS-Transistoren (QP1 & QP2, QP3 & QP4) des komplementären Leitfähigkeitstyps umfaßt, und

einen Steuerkreis zur Erzeugung von Leseverstärker-Aktivierungssignalen (SN1, SN2) zur sequentiellen Aktivierung der Vielzahl von Leseverstärkern (SA1, SA2) in einer vorgegebenen Reihenfolge (SA2, SA1), beginnend mit dem (SA2) Leseverstärker (SA1, SA2) in demjenigen Block, der die gerade adressierte (MC1) Speicherzelle (MC1,...) umfaßt, wobei

jeder Leseverstärker (SA1, SA2,...) und jeder Rücksetzkreis (RE1, RE2,...) mit dem entsprechenden geteilten Bitleitungspaar (BL1 & $\overline{\text{BL1}}$, BL2 & $\overline{\text{BL2}}$,...) verbunden ist, und jedes Bitleitungspaar (BL1 & $\overline{\text{BL1}}$, BL2 & $\overline{\text{BL2}}$,...) vom nächsten (BL2 & $\overline{\text{BL2}}$,...) über ein Paar von Schaltern (QT1 & $\overline{\text{QT2}}$) getrennt ist und in jeder Bitleitung ein Schalter (QT1, QT2) liegt, und wobei ferner vorgesehen ist

eine Steuereinrichtung (TG) zur Steuerung des Betriebs des einen Schalterpaars (QT1 & QT2) entsprechend dem Paar von Leseverstärker-Aktivierungssignalen (SN1, SN2), das den Leseverstärkern (SA1, SA2) in den dem besagten einen Schalterpaar (QT1 & QT2) unmittelbar benachbarten Blöcken zugeführt wird, um dieses eine Schalterpaar (QT1 & QT2) in den leitfähigen Zustand zu versetzen und demjenigen Signal des Leseverstärker-Aktivierungssignalpaars (SN1, SN2) zu folgen und auf das anzusprechen, das als erstes aktiviert wird.

2. Halbleiterspeicher nach Anspruch 1, wobei die Steuereinrichtung (TG) ein NOR-Glied (NG) umfaßt, um als Eingänge die Leseverstärker-Aktivierungssignale (SN1, SN2) für diejenigen beiden Leseverstärker (SA1, SA2) zu empfangen, die in den beiden dem entsprechenden einen Schalterpaar (QT1 & QT2) unmittelbar benachbarten Blöcken liegen.

3. Halbleiterspeicher nach Anspruch 2, wobei die Steuereinrichtung (TG) Inverter (I1, I2, I3) umfaßt, die in Serie mit dem Ausgang des NOR-Glieds (NG) liegen.

## Revendications

1. Une mémoire vive dynamique (figure 5) comprenant :

un ensemble de lignes de bit associées par paires, chaque paire de lignes de bit étant divisée en un ensemble de paires de lignes de bit divisées (BL1 & $\overline{\text{BL1}}$, BL2 $\overline{\text{BL2}}$) ;

un ensemble de cellules de mémoire (MC1,...) divisé en blocs, chaque bloc de cellules de mémoire étant connecté à l'une respective des paires de lignes de bit divisées (BL1 & $\overline{\text{BL1}}$, BL2 & $\overline{\text{BL2}}$,...) et ayant de chaque côté, respectivement un amplificateur de lecture (SA1, SA2, ...) comportant un ou plusieurs transistors MOS (QN1 & QN2, QN3 & QN4...) d'un type de conductivité, et un circuit de restauration (RE1, RE2) comportant un ou plusieurs transistors MOS (QP1 & QP2, QP3 & QP4) du type de conductivité complémentaire ; et

un circuit de commande destiné à générer des signaux d'activation de circuits de restauration (SN1, SN2) pour activer séquentiellement l'ensemble d'amplificateurs de lecture (SA1, SA2) dans un ordre prédéterminé (SA2, SA1), en commençant par celui (SA2) des amplificateurs de lecture (SA2, SA1) qui fait partie de celui des blocs qui contient celle (MC1) des cellules de mémoire (MC1,...) qui est adressée, dans laquelle

chaque amplificateur de lecture respectif (SA1, SA2,...) et chaque circuit de restauration respectif (RE1, RE2,...) sont connectés à la paire de lignes de bit divisées respectives (BL1 & $\overline{\text{BL1}}$, BL2 & $\overline{\text{BL2}}$,...) ; et

chaque paire de lignes de bit divisées respective (BL1 & $\overline{\text{BL1}}$, BL2 & $\overline{\text{BL2}}$,...) est séparée de la suivante (BL2 & $\overline{\text{BL2}}$,...) par une paire d'éléments de commutation (QT1 & QT2), avec un élément de commutation (QT1, QT2) dans chaque ligne de bit ; et dans laquelle il existe :

des moyens de commande (TG) destinés à commander le fonctionnement de la paire d'éléments de commutation (QT1 & QT2), sous la dépendance de la paire de signaux d'activation d'amplificateur de lecture (SN1, SN2) qui sont respectivement appliqués aux amplificateurs de lecture (SA1, SA2) dans les blocs qui sont immédiatement adjacents à la paire d'éléments de commutation (QT1 & QT2), et qui font passer la paire d'éléments de commutation (QT1 & QT2) à l'état conducteur sous la dépendance de celui des signaux de la paire de signaux d'activation d'amplificateur de lecture (SN1, SN2) qui devient actif en premier, et à la suite du passage de ce signal à l'état actif.

2. Une mémoire à semiconducteurs selon la revendication 1, dans laquelle les moyens de commande (TG) comprennent une porte NON-OU (NG) qui est conçue pour recevoir à titre de signaux d'entrée les signaux d'activation d'amplificateur de lecture (SN1, SN2) pour les deux amplificateurs de lecture (SA1, SA2) qui font partie des deux blocs immédiatement adjacents à la paire correspondante d'éléments de commutation (QT1 & QT2).

3. Une mémoire à semi-conducteurs selon la revendication 2, dans laquelle les moyens de commande (TG) comprennent des inverseurs (I1, I2, I3) qui sont connectés en série à la sortie de la porte NON-OU (NG).

# FIG.1

EP 0 238 228 B1

# FIG.2

# FIG.3

EP 0 238 228 B1

# FIG. 4

# FIG.5

EP 0 238 228 B1

# FIG. 6

EP 0 238 228 B1

# FIG.7A

# FIG.7B